# EUROPÄISCHE PATENTSCHRIFT

(11) **EP 3 304 574 B1**
(45) Veröffentlichungstag und Bekanntmachung des Hinweises auf die Patenterteilung: **22.05.2019**
(21) Anmeldenummer: 16726873.9
(22) Anmeldetag: 03.06.2016
(51) Int. Cl.: H01J 37/32, H05H 1/24

(54) **VORRICHTUNG ZUR PLASMABEHANDLUNG VON INSBESONDERE BANDFÖRMIGEN OBJEKTEN**
DEVICE FOR THE PLASMA TREATMENT OF OBJECTS, IN PARTICULAR IN STRIP FORM
DISPOSITIF DE TRAITEMENT AU PLASMA D'OBJETS EN PARTICULIER EN FORME DE BANDE

(30) Priorität: 04.06.2015 DE 102015108884
(43) Veröffentlichungstag der Anmeldung: 11.04.2018
(73) Patentinhaber: Hochschule für Angewandte Wissenschaft und Kunst Hildesheim/Holzminden/Göttingen, 31134 Hildesheim (DE)
(72) Erfinder: VIÖL, Wolfgang, 37139 Adelebsen (DE); WIENEKE, Stephan, 37079 Göttingen (DE); GREDNER, Alexander, 34292 Ahnatal (DE)
(74) Vertreter: REHBERG HÜPPE + PARTNER
(86) Internationale Anmeldenummer: PCT/EP2016/062592
(87) Internationale Veröffentlichungsnummer: WO 2016/193406

(56) Entgegenhaltungen:
- EP-A1- 2 205 049
- WO-A1-02/095115

## Beschreibung

### TECHNISCHES GEBIET DER ERFINDUNG

Die Erfindung bezieht sich auf eine Vorrichtung zur Plasmabehandlung eines Objekts mit den Merkmalen des Oberbegriffs des unabhängigen Patentanspruchs 1.

Mit einer solchen Vorrichtung wird eine dielektrisch behinderte Gasentladung hervorgerufen. Ein im Bereich einer dielektrisch behinderten Gasentladung entstehendes physikalisches Plasma wird auch als kaltes Plasma bezeichnet, da die Gastemperatur der reaktiven Spezies in dem Plasma gegenüber der Umgebungstemperatur nicht wesentlich erhöht ist. Die Wirkung einer Plasmabehandlung mit einem solchen kalten Plasma beschränkt sich daher im Wesentlichen auf die Wirkung der in dem Plasma enthaltenen reaktiven Spezies, d. h. insbesondere der Radikale des Gases, in dem die Gasentladung hervorgerufen wird. Durch eine Behandlung mit einem kalten Plasma werden Objekte an ihrer Oberfläche physikalisch und/oder chemisch aktiviert, so dass z. B. ein nachfolgend zu der Oberfläche hergestellter Klebkontakt eine besonders gute Haftung aufweist.

### STAND DER TECHNIK

Aus der WO 2013 156 352 A2 ist eine Plasmaroller genannte Vorrichtung zur Plasmabehandlung einer Oberfläche eines Objekts bekannt. Die Vorrichtung weist eine Walze auf, die eine Elektrode innerhalb eines zylindermantelförmigen Kontaktmantels aus einem Dielektrikum umfasst. Die Elektrode ist kapazitiv an einen Wechselhochspannungsgenerator angekoppelt, d. h. über den Kontaktmantel und ein zusätzliches, vor einer Kopplungselektrode angeordnetes Dielektrikum hinweg. Die Walze ist zum Abrollen über die zu behandelnde Oberfläche vorgesehen, wobei der Kontaktmantel mit der Oberfläche in linienförmigem Kontakt steht. Beidseitig des linienförmigen Kontakts treten dielektrisch behinderte Gasentladungen zwischen der Oberfläche des Objekts und der Oberfläche des Kontaktmantels auf. Dies gilt zumindest bei Objekten aus elektrisch leitfähigem Material. Objekte aus nicht elektrisch leitfähigem Material müssen vielfach an eine Gegenelektrode angekoppelt werden, der gegenüber der Wechselhochspannungsgenerator die Wechselhochspannung erzeugt, um die Gasentladung zur Plasmabehandlung der Oberfläche des Objekts hervorzurufen. Die bekannte Vorrichtung kann als batterie- oder akkumulatorbetriebenes Handgerät mit einem Handgriff zum Bewegen der Walze über das Objekt ausgebildet sein. Dabei beschränkt sich die aktuelle Plasmabehandlung der Oberfläche des Objekts auf die beiden Bereiche längs des linienförmigen Kontakts zwischen dem Kontaktmantel und der Oberfläche des Objekts.

Aus der US 6 083 355 A ist eine Vorrichtung zur Plasmabehandlung von bandförmigen Objekten bekannt. Die Vorrichtung umfasst eine Walze mit einem als Zylinderelektrode ausgebildeten Kontaktmantel, der von dem zu behandelnden Objekt über einen Umschlingungswinkel hinweg umschlungen wird, und mehrere dem Kontaktmantel über einen Spalt hinweg gegenüberliegende konkave Gegenelektroden. Zwischen der Zylinderelektrode und den Gegenelektroden wird eine Wechselhochspannung angelegt, die eine grundsätzlich nicht dielektrisch behinderte Gasentladung in dem Spalt erzeugt, durch den hindurch das bandförmige Material durch Verdrehen der Walze hindurchgefördert wird. Die Plasmabehandlung erfolgt dabei in einer definierten Gasatmosphäre bei reduziertem Druck.

Eine weitere Vorrichtung zur Plasmabehandlung eines bandförmigen Objekts ist aus der WO 2009 096 785 A1 bekannt. Hier ist eine Walze, die eine zylinderförmige Elektrode ausbildet und das zu behandelnde Objekt über einen Umschlingungswinkel hinweg abstützt, gegenüber einer konkaven Gegenelektrode angeordnet. Durch einen Spalt zwischen der Elektrode und der Gegenelektrode läuft zusammen mit dem bandförmigen Objekt ein Maskenband hindurch. Das Maskenband definiert die Bereiche des bandförmigen Materials, die dem Plasma ausgesetzt werden, welches durch eine dielektrisch behinderte Ladung zwischen der Elektrode und der Gegenelektrode hervorgerufen wird. Die dielektrische Behinderung der Entladung wird durch ein vor der Gegenelektrode angeordnetes Dielektrikum oder eine nicht elektrisch leitfähige Beschichtung der Elektrode bewirkt.

Aus der WO 2012 097 904 A2 ist eine dielektrische Koplanarentladungsquelle für eine Oberflächenbehandlung unter Atmosphärendruck bekannt. Die Koplanarentladungsquelle umfasst zwei gestreckte Elektroden, die eine gemeinsame Abschirmung aus Dielektrikum aufweisen und die parallel zueinander und parallel zu einer freien Oberfläche der Abschirmung verlaufen. In der freien Oberfläche der Abschirmung sind quer zu den Elektroden, d. h. in Richtung ihres Abstands, verlaufende Rillen vorgesehen.

Aus der WO 02 023 960 A1 ist es zur Plasmabehandlung von bahnförmigem Material bekannt, dieses über zwei quer zu dem bahnförmigen Material und parallel zueinander hinter einer gemeinsamen dielektrischen Abschirmung ortsfest angeordneten Elektroden hinweg zu führen, wobei zwischen den Elektroden eine Wechselhochspannung anliegt, die eine Gasentladung über der dielektrischen Abschirmung hervorruft. Hierdurch soll ein Stand der Technik verbessert werden, bei dem das bahnförmige Material über eine Walze gespannt unter einer stationären Elektrode hindurchläuft, an der eine Wechselhochspannung gegenüber einer zylinderförmigen Elektrode in der Walze anliegt, wobei die zylinderförmige Elektrode in der Walze von einem Kontaktmantel aus dielektrischem Material umschlossen ist.

Aus der WO 02 095 115 A1 und der zur selben Patentfamilie gehörigen US 2004 194 223 A1 ist eine Vorrichtung zur Plasmabehandlung mit den Merkmalen des Oberbegriffs des unabhängigen Patentanspruchs 1 bekannt. Dabei sind Elektroden und Gegenelektroden, die an einen Wechselhochspannungsgenerator angeschlossen sind, in einen dielektrischen Körper eingebettet, der einen Kontaktmantel einer Walze ausbildet. Die Elektroden folgen in Umfangsrichtung der Walze wechselweise aufeinander, und zwischen jeweils einer Elektrode und der ihr benachbarten Gegenelektrode ist eine Hilfselektrode näher an der Oberfläche des dielektrischen Körpers angeordnet, aber ebenso wie die Elektroden und die Gegenelektroden vollständig in den dielektrischen Körper eingebettet. Alle Hilfselektroden sind elektrisch miteinander verbunden. Die Elektroden, die Gegenelektroden und die Hilfselektroden sind jeweils in axialer Richtung der Walze langgestreckte Körper, wobei die Gegenelektroden und die Elektroden Metallbleche und die Hilfselektroden Metalldrähte sind.

Aus der EP 2 205 049 A1 ist eine Vorrichtung zur Behandlung eines Objekts unter Anwendung eines Plasmaprozesses bekannt. Die Vorrichtung weist einen Plasmareaktor auf, der einen mit einer dielektrischen Schicht abgedeckten Metallzylinder umfasst. Weiterhin weist die Vorrichtung eine Elektrodenstruktur auf, die radial außerhalb des Metallzylinders angeordnet ist, um den Plasmaprozess zu erzeugen. Die Vorrichtung umfasst auch eine Abstützstruktur, um das zu behandelnde Objekt in einer vordefinierten Entfernung von dem Plasmareaktor anzuordnen. Die Elektrodenstruktur weist ein Elektrodenelement auf, das an oder in der dielektrischen Schicht angeordnet ist, sowie ein sekundäres Elektrodenelement, das radial außerhalb und beabstandet zu der dielektrischen Schicht angeordnet ist. Bei der Elektrodenstruktur kann eine Mehrzahl von Elektroden elektrisch miteinander verbunden sein. Die Abstützstruktur weist eine Führungswalze zum Führen des Objekts längs einer Oberfläche des Reaktors auf.

### AUFGABE DER ERFINDUNG

Der Erfindung liegt die Aufgabe zugrunde, eine Vorrichtung zur Plasmabehandlung von insbesondere bandförmigen Objekten aufzuzeigen, die die Merkmale des Oberbegriffs des unabhängigen Patentanspruchs 1 aufweist und bei der eine flächige Behandlung der Objekte erfolgt, ohne dass diese zwischen der Elektrode und der Gegenelektrode hindurchgefädelt werden müssen.

### LÖSUNG

Die Aufgabe der Erfindung wird durch eine Vorrichtung mit den Merkmalen des unabhängigen Patentanspruchs 1 gelöst. Vorteilhafte Ausführungsformen der erfindungsgemäßen Vorrichtung sind in den abhängigen Patentansprüchen definiert.

### BESCHREIBUNG DER ERFINDUNG

Bei einer erfindungsgemäßen Vorrichtung zur Plasmabehandlung eines Objekts bestehen eine Elektrode und eine Gegenelektrode jeweils aus elektrisch leitfähigem Material. Ein Wechselhochspannungsgenerator ist ausgebildet und angeschlossen, um mit einer Wechselhochspannung eine Gasentladung zwischen der Elektrode und der Gegenelektrode hervorzurufen. Eine um eine Walzenachse drehbar gelagerte Walze der erfindungsgemäßen Vorrichtung weist einen Kontaktmantel zum Kontaktieren des zu behandelnden Objekts auf. In diesem Kontaktmantel sind die Elektrode und die Gegenelektrode nebeneinander angeordnet. Dabei versteht es sich, dass die Elektrode und die Gegenelektrode innerhalb des Kontaktmantels gegeneinander elektrische isoliert sind. Zudem weist der Kontaktmantel eine die Elektrode und die Gegenelektrode bedeckende Deckschicht aus dielektrischem Material auf. Dieses Material bildet eine dielektrische Barriere, die zwischen der Elektrode und der Gegenelektrode mit der Gasentladung in Reihe geschaltet ist, um die Gasentladung dielektrisch zu behindern, zumindest im Wesentlichen aus. Um das Zünden der Gasentladung zwischen der Elektrode und der Gegenelektrode zu erleichtern, ist oberhalb der Elektrode und/oder oberhalb der Gegenelektrode eine durch die Deckschicht von der Elektrode oder der Gegenelektrode getrennte, aber am Außenumfang des Kontaktmantels frei liegende linienförmige Zündelektrode aus elektrisch leitfähigem Material angeordnet. Die Zündelektrode koppelt kapazitiv an die unter ihr liegende Elektrode bzw. Gegenelektrode an und zu ihr hin bilden sich Feldspitzen des elektrischen Felds über dem Kontaktmantel aus. Diese Feldspitzen sorgen für ein sicheres Zünden der Gasentladung zwischen den durch die Zündelektroden vorgegebenen Bereichen des Kontaktmantels. Durch den über die Gasentladung fließenden Strom gleichen sich die Feldstizen an den Zündelektroden aber schnell aus, so dass ihr Vorhandensein einer gleichmäßig verteilten Gasentladung nicht entgegen steht. Wenn mehrere Zündelektroden vorgesehen sind, sind diese auch voneinander elektrisch getrennt.

Durch die Anordnung der Elektrode und der Gegenelektrode in dem Kontaktmantel bildet sich die Gasentladung, die mit dem Wechselhochspannungsgenerator zwischen der Elektrode und der Gegenelektrode hervorgerufen wird, über dem Kontaktmantel aus. Das in dem Bereich dieser Gasentladung über dem Kontaktmantel gelangende oder dort hindurchgeführte Objekt wird mit dem durch die Gasentladung erzeugten Plasma behandelt.

Bei der erfindungsgemäßen Vorrichtung wird die Plasmabehandlung über den Umfang der Walze hinweg realisiert, ohne dass es hierfür einer diesem Umfang gegenüber anzuordnenden Gegenelektrode bedarf. Das Objekt wird dabei im Zulauf zu der Walze der erfindungsgemäßen Vorrichtung an seiner Oberfläche dem Plasma ausgesetzt, die sich anschließend über den Umschlingungswinkel um die Walzenachse hinweg an dem Kontaktmantel der Walze abstützt. Über diesen Umschlingungswinkel hinweg erfolgt die Plasmabehandlung des Objekts auf seiner der Walze abgekehrten Seite, ohne dass irgendein Teil der erfindungsgemäßen Vorrichtung in der unmittelbaren Nähe dieser der Walze abgekehrten Seite angeordnet wäre. Dies erweist sich als äußerst vorteilhaft, wenn es sich bei dem behandelten Objekt um ein Klebeband handelt. Das Klebeband kann mit seiner nicht klebenden Seite an dem Kontaktmantel abgestützt werden, während es an seiner klebenden Seite zwecks Aktivierung plasmabehandelt wird. Dabei liegt das Klebeband mit seiner klebenden Seite frei. Es besteht also keine Gefahr, dass es in unerwünschter Weise irgendwo an der Vorrichtung anhaftet.

Die, um die Gasentladung dielektrisch zu behindern, mit der Gasentladung in Reihe geschaltete dielektrische Barriere kann auch noch an einer anderen Stelle als zwischen der Elektrode und der Gegenelektrode in dem Stromkreis des Wechselhochspannungsgenerators angeordnet sein, an der sie die Gasentladung zwischen der Elektrode und der Gegenelektrode ebenfalls dielektrisch behindert. Beispielsweise kann die Elektrode oder die Gegenelektrode über die dielektrische Barriere hinweg kapazitiv an den Wechselhochspannungsgenerator angekoppelt sein. Allein entscheidend ist, dass die dielektrische Barriere insgesamt das Integral eines während jeder Halbwelle der Wechselhochspannung, d. h. solange die Wechselhochspannung ihre Polarität beibehält, durch die Gasentladung fließenden Stroms auf einen Maximalwert begrenzt.

Wenn eine flächig ausgebildete Elektrode innerhalb des Kontaktmantels neben einer flächig ausgebildeten Gegenelektrode angeordnet ist, besteht die Gefahr, dass sich die Gasentladung auf den Bereich oberhalb des kleinsten Abstands der Gegenelektrode von der Elektrode konzentriert. Um die Gasentladung auch über der Elektrode und der Gegenelektrode zu verteilen, kann die Dicke der die Elektrode und die Gegenelektrode bedeckenden Deckschicht oberhalb der Elektrode und/oder Gegenelektrode mit zunehmendem Abstand zu der Gegenelektrode bzw. zu der Elektrode abnehmen. Damit ergibt sich eine Verteilung des elektrischen Felds, bei der dieses auch weiter entfernt von dem kleinsten Abstand der Gegenelektrode zu der Elektrode für das Hervorrufen der Gasentladung ausreichend ist. In Verbindung mit der mindestens einen erfindungsgemäßen Zündelektrode können sich auch Vorteile für eine flächige Verteilung des Gasentladung ergeben, wenn die Dicke der die Elektrode und die Gegenelektrode bedeckenden Deckschicht oberhalb der Elektrode und/oder Gegenelektrode mit zunehmendem Abstand zu der Gegenelektrode bzw. zu der Elektrode zunimmt. In jedem Fall kein ein Winkel zwischen der jeweiligen Elektrode oder Gegenelektrode und der Oberfläche des Kontaktmantels bis zu 10 ° und konkret etwa 5 ° betragen. Unabhängig von einer konischen oder zylindrischen Ausbildung der Elektrode und/oder Gegenelektrode kann die sie bedeckende Deckschicht aus dem dielektrischem Material etwa 1 bis 10 mm oder insbesondere 2 bis 8 mm dick sein.

In einer speziellen Ausführungsform der erfindungsgemäßen Vorrichtung weist der Wechselhochspannungsgenerator einen in der Walze angeordneten Transformator auf, dessen Primärwicklung drehfest auf einem sich nicht mit der Walze um die Walzenachse drehenden Kern angeordnet ist und dessen Sekundärwicklung drehfest an dem Kontaktmantel gelagert ist, so dass er sich mit der Walze um die Walzenachse dreht, und endseitig an die Elektrode einerseits und die Gegenelektrode andererseits angeschlossen ist. Der Primärwicklung kann dann eine Wechselspannung geringerer Amplitude zugeführt werden, die von dem Transformator in der Walze auf eine höhere Spannung hochtransformiert wird. Damit ist die Walze der einzige Teil der erfindungsgemäßen Vorrichtung, an dem die Wechselspannung anliegt, wobei sie durch die Deckschicht aus dielektrischem Material über der Elektrode und der Gegenelektrode abgeschirmt ist. Zudem müssen keine direkten elektrischen Kontakte zwischen der Walze und einem nichtdrehenden Anschluss des Wechselhochspannungsgenerators hergestellt werden.

In einer Ausführungsform der erfindungsgemäßen Vorrichtung folgen die Elektrode und die Gegenelektrode in Richtung der Walzenachse aufeinander. Die Elektrode und die Gegenelektrode können dabei im Wesentlichen identisch, ringförmig oder zylindermantelabschnittförmig ausgebildet sein. Bei dieser Ausführungsform der erfindungsgemäßen Vorrichtung können auch mehrere Paare aus jeweils einer Elektrode und einer Gegenelektrode in Richtung der Walzenachse aufeinander folgen.

Um bei dieser Ausführungsform der erfindungsgemäßen Vorrichtung die Gasentladung gleichmäßig über den Kontaktmantel zu verteilen, kann der Kontaktmantel an seinem Außenumfang mit in Umfangsrichtung um die Walzenachse verlaufenden Rillen versehen sein, die für eine gleichmäßige Verteilung von Feldspitzen über den Kontaktmantel hinweg sorgen.

In einer anderen Ausführungsform der erfindungsgemäßen Vorrichtung sind mehrere Elektroden und mehrere Gegenelektroden in Umfangsrichtung um die Walzenachse alternierend in dem Kontaktmantel angeordnet. Bei dieser Ausführungsform der erfindungsgemäßen Vorrichtung kann der Wechselhochspannungsgenerator angeschlossen sein, um die Wechselhochspannung selektiv zwischen den Elektroden und den Gegenelektroden zu erzeugen, die sich aktuell innerhalb eines vorgegebenen Umfangswinkels um die Walzenachse befinden. Entsprechend bildet sich dann die Gasentladung nicht über dem gesamten Kontaktmantel aus, sondern nur in dem vorgegebenen Umfangswinkel. Dieser vorgegebene Umfangswinkel kann insbesondere auf einen Umschlingungswinkel um die Winkelachse fokussiert sein, über den hinweg der Kontaktmantel das zu behandelnde bandförmige Objekt abstützt.

Um bei dieser Ausführungsform der erfindungsgemäßen Vorrichtung die Gasentladung gleichmäßig über den Kontaktmantel zu verteilen, kann der Kontaktmantel an seinem Außenumfang mit in parallel zu der Walzenachse verlaufenden Rillen versehen sein, die für eine gleichmäßige Verteilung von Feldspitzen über den Kontaktmantel hinweg sorgen.

Unabhängig von ihrem Verlauf können die zur Verteilung der Gasentladung über den Kontaktmantel vorgesehenen Rillen in dem Kontaktmantel eine Tiefe und eine Breite von jeweils 0,05 mm bis wenige Millimeter, typischerweise von 0,1 mm bis zu 1 mm, aufweisen und den Außenumfang des Kontaktmantels beispielsweise sägezahnförmig oder nach Art einer Dreiecksfunktion profilieren.

An dieser Stelle ist festzuhalten, dass sich alle Elektroden und alle Gegenelektroden bei der erfindungsgemäßen Vorrichtung nicht unterscheiden müssen, außer dass sie jeweils mit unterschiedlichen Ausgängen des Wechselhochspannungsgenerators verbunden sind, zwischen denen die von diesem generierte Wechselhochspannung anliegt. Im Normalfall ist dies auch ihr einziger Unterschied. Bei einer symmetrischen Wechselhochspannung kehren sich die Funktionen jeder Elektrode und jeder Gegenelektrode halbwellenweise vollständig um, so dass es auch keinen funktionalen Unterschied gibt.

In einigen Ausführungsformen der erfindungsgemäßen Vorrichtung kann der Wechselhochspannungsgenerator Wechselhochspannungen zwischen etwa 5.000 V und 50.000 V erzeugen.

In diesen und anderen Ausführungsformen der erfindungsgemäßen Vorrichtung kann der Wechselhochspannungsgenerator die Wechselhochspannung mit einer Frequenz zwischen etwa 100 kHz und etwa 3 MHz oder zwischen 150 kHz und etwa 1 MHz oder zwischen 200 kHz und 600 kHz erzeugen. Durch diese Frequenzen der Wechselhochspannung wird eine erhöhte Betriebssicherheit der erfindungsgemäßen Vorrichtung gewährleistet, da auf Grund des Skineffektes bei einer versehentlichen Berührung von Teilen der Vorrichtung, an denen diese Wechselhochspannung anliegt, der resultierende elektrische Strom lediglich die Oberfläche des Körpers der berührenden Person entlang fließt und nicht tief in darunter liegendes Gewebe eindringt. Eine Gefährdung des Benutzers der erfindungsgemäßen Vorrichtung kann so ausgeschlossen werden.

Zusätzlich kann die Wechselhochspannung getaktet werden, um den thermischen Eintrag in das zu behandelnde Objekt und auch in den Körper einer mit der Wechselhochspannung in Berührung kommenden Person zu begrenzen. Dabei ist unter einer Taktung der Wechselhochspannung eine Unterbrechung der Wechselhochspannung nach jeweils einer Gruppe von Hochspannungspulsen wechselnder Polarität zu verstehen. Eine solche Gruppe kann z. B. einige bis einige zehn Hochspannungspulse wechselnder Polarität umfassen.

Bei Taktung der Wechselhochspannung kann durch Variation der Anzahl der Hochspannungspulse in jeder Gruppe und/oder einer Gruppenfolgefrequenz, mit der die einzelnen Gruppen der Hochspannungspulse aufeinander folgen, eine elektrische Leistung der durch die Wechselhochspannung hervorgerufenen Gasentladung auf einen gewünschten Wert, insbesondere einen gewünschten Wert pro Flächeneinheit der Oberfläche des behandelten Objekts eingestellt werden. Diese Flächenleistungsdichte kann zwischen 0,1 bis 10 W/cm² liegen.

Die Gruppenfolgefrequenz der Gruppen der Hochspannungspulse kann in einem Bereich jenseits der vom Menschen hörbaren Frequenzen liegen, d. h. mindestens 16 kHz betragen, so dass der Betrieb der Vorrichtung keine Geräusche mit der Wiederholungsfrequenz verursacht. Die Gruppenfolgefrequenz kann auch deutlich höher als die Grenze des hörbaren Bereichs liegen, d. h. mindestens 20 kHz oder mindestens 30 kHz betragen, so dass mit ihr keinerlei vom Menschen wahrnehmbare Schwingungsanregungen verbunden sind.

Die erfindungsgemäße Vorrichtung kann neben der Walze ein Drehlager mit einer parallel zu der Walzenachse verlaufenden Drehachse für das zu einer Vorratsrolle aufgewickelte zu behandelnde bahnförmige Objekt aufweisen. Dabei kann der Kontaktmantel vorgesehen sein, das von der Vorratsrolle ablaufende Objekt über einen definierten Umschlingungswinkel um die Walzenachse abzustützen, bis es z. B. mit dem Kontaktmantel an eine Oberfläche angedrückt wird oder von der Walze zu einer weiteren Walze hin abläuft.

Um das bandförmige Objekt mit der Walze oder mit einer separaten, um eine zu der Walzenachse parallelen Drehachse drehbar gelagerten Andrückwalze an eine Oberfläche anzudrücken, kann an der Vorrichtung ein Handgriff vorgesehen sein. Die Vorrichtung ist dann insbesondere zum Abrollen eines Klebebands mit seiner klebenden Seite auf die Oberfläche vorgesehen, wobei die klebende Seite zuvor durch Plasmabehandlung aktiviert wurde. Zusätzlich kann die Vorrichtung auch für eine Plasmavorbehandlung der Oberfläche des Körpers vorgesehen sein, auf die das bandförmige Objekt aufgebracht wird. Dazu kann das Plasma genutzt werden, das sich im Bereich der Gasentladung über den Kontaktmantel auf der Seite des bandförmigen Materials ausbildet, wenn die Walze selbst zum Andrücken des bandförmigen Materials an die Oberfläche genutzt wird. Für die Plasmavorbehandlung der Oberfläche des Körpers kann aber auch eine zusätzliche, um eine zu der Walzenachse parallele Drehachse drehbar gelagerte Plasmabehandlungswalze vorgesehen sein. Diese Plasmabehandlungswalze kann genauso aufgebaut sein wie die Walze der Vorrichtung zur Behandlung des bandförmigen Materials. Es kann sich zum Beispiel aber auch um eine Walze handeln, wie sie von dem Plasmaroller gemäß der WO 2013/156352 A2 bekannt ist.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einer dielektrischen Barriere die Rede ist, ist dies so zu verstehen, dass genau eine dielektrische Barriere, zwei dielektrische Barrieren oder mehr dielektrische Barrieren vorhanden sind. Die in den Patentansprüchen genannten Merkmale können durch andere Merkmale ergänzt werden oder die einzigen Merkmale sein, aus denen die jeweilige Vorrichtung besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: zeigt eine erste Ausführungsform der erfindungsgemäßen Vorrichtung zur Plasmabehandlung von insbesondere bandförmigen Objekten mit in axialer Richtung aufeinanderfolgenden Elektroden.
- **Fig. 2**: zeigt eine zweite Ausführungsform der erfindungsgemäßen Vorrichtung zur Plasmabehandlung von insbesondere bandförmigen Objekten mit in axialer Richtung aufeinanderfolgenden Elektroden.
- **Fig. 3**: zeigt eine dritte Ausführungsform der erfindungsgemäßen Vorrichtung zur Plasmabehandlung von insbesondere bandförmigen Objekten mit in axialer Richtung aufeinanderfolgenden Elektroden.
- **Fig. 4**: zeigt eine vierte Ausführungsform der erfindungsgemäßen Vorrichtung zur Plasmabehandlung von insbesondere bandförmigen Objekten mit in axialer Richtung aufeinanderfolgenden Elektroden.
- **Fig. 5**: zeigt eine fünfte Ausführungsform der erfindungsgemäßen Vorrichtung zur Plasmabehandlung von insbesondere bandförmigen Objekten mit in Umfangsrichtung aufeinanderfolgenden Elektroden.
- **Fig. 6**: zeigt eine erste Ausführungsform eines Klebebandabrollers als Anwendung der erfindungsgemäßen Vorrichtung; und
- **Fig. 7**: zeigt eine zweite Ausführungsform des Klebebandabrollers als Anwendung der erfindungsgemäßen Vorrichtung.

### FIGURENBESCHREIBUNG

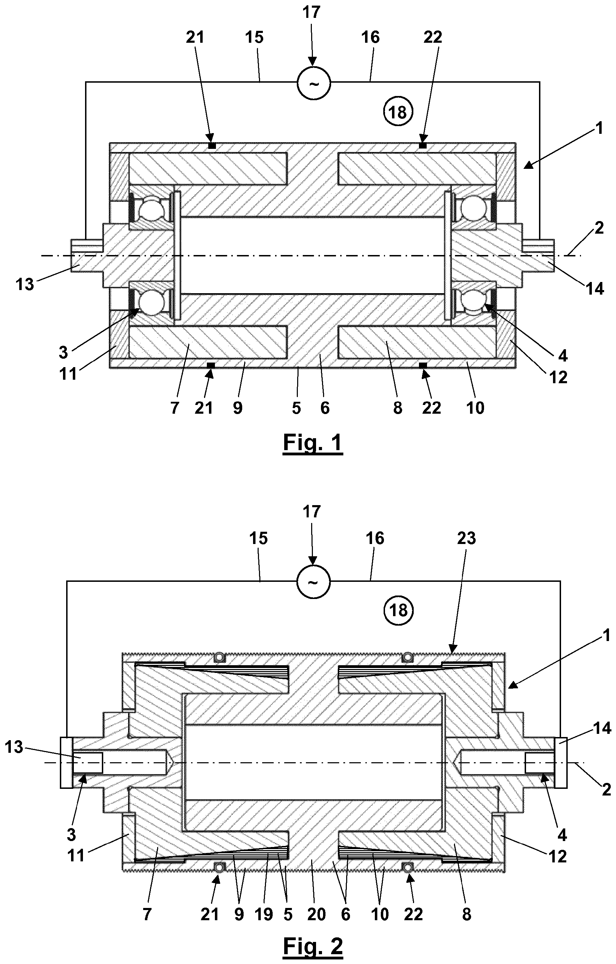

Die in **Fig. 1** illustrierte Vorrichtung umfasst eine Walze 1, die um eine Walzenachse 2 mittels zweier axial voneinander beabstandeter Drehlager 3 und 4 verdrehbar gelagert ist. Die Walze 1 weist einen Kontaktmantel 5 auf, der zum Kontaktieren eines Objekts, insbesondere eines bandförmigen Objekts, vorgesehen ist, indem das bandförmige Objekt über einen Umschlingungswinkel um die Walzenachse 2 herum am Außenumfang des Kontaktmantels 5 anliegt. Der Kontaktmantel 5 ist aus einem dielektrischen Material 6 ausgebildet. In den Kontaktmantel 5 sind eine Elektrode 7 und eine Gegenelektrode 8 eingebettet, die in axialer Richtung voneinander beabstandet sind, wobei dieser Abstand durch das dielektrische Material 6 ausgefüllt ist. Auf diese Weise sind die Elektroden 7, 8 in dem Kontaktmantel 5 elektrisch voneinander isoliert. Zudem liegen sowohl die Elektrode 7 als auch die Gegenelektrode 8 unter einer Deckschicht 9 bzw. 10 aus dem dielektrischen Material 6 des Kontaktmantels 5, d. h. nicht direkt am Außenumfang des Kontaktmantels 5. Axial nach außen sind die Elektroden 7, 8 durch elektrisch isolierende Stirndeckel 11, 12 abgedeckt, die hier auch die Drehlager 3, 4 nach axial außen abdecken. Die Drehlager 3, 4 sind jedoch elektrisch leitend ausgebildet und schließen die Elektroden 7, 8 elektrisch an nicht drehende Lagerbolzen 13, 14 aus elektrisch leitfähigem Material an. An diese Lagerbolzen 13, 14 sind zwei Anschlüsse 15, 16 eines Wechselhochspannungsgenerators 17 angeschlossen, zwischen denen der Wechselhochspannungsgenerator 17 eine Wechselhochspannung generiert. Diese über die Lagerbolzen 13, 14 und die Drehlager 3, 4 zwischen den Elektroden 7 und 8 anliegende Wechselhochspannung ruft über dem Kontaktmantel 5 eine dielektrisch behinderte Gasentladung in einer Gasatmosphäre 18 in der Umgebung der Walze 1 hervor. Diese Gasentladung erstreckt sich in Umfangsrichtung um die Walzenachse 2 über den gesamten Kontaktmantel 5. Entsprechend wird ein an dem Kontaktmantel 5 anliegendes bandförmiges Objekt mit dem durch die Gasentladung hervorgerufenen Plasma behandelt. Die Gasentladung ist hier durch das auf allen Wegen zwischen den Elektroden 7 und 8 als dielektrische Barriere wirksame dielektrische Material 6 dielektrisch behindert. Das durch die Gasentladung erzeugte Plasma ist daher ein kaltes Plasma. Um das Zünden und die gleichmäßige Verteilung der durch die Wechselhochspannung der Wechselhochspannungsgenerators 14 erzeugten Gasentladung zu fördern ist oberhalb der Elektrode 7 und der Gegenelektrode 8 jeweils eine am Außenumfang des Kontaktmantels 5 freiliegende, aber über diesen Außenumfang nicht überstehende linienförmige Zündelektrode 21, 22 aus elektrisch leitfähigem Material angeordnet. Die Zündelektroden 21, 22 erstrecken sich ringförmig um die Walzenachse 2, sie stehen zwar nicht in direktem elektrischen Kontakt zu der unter ihnen liegenden Elektrode 7 bzw. 8, sind aber kapazitiv an diese angekoppelt. Die Zündelektroden 21, 22 resultieren in Feldspitzen des durch die Wechselhochspannung des Wechselhochspannungsgenerators 17 über dem Kontaktmantel 5 ausgebildeten elektrischen Felds. Damit führen sie zu einer sicheren Zündung der Gasentladung zwischen den Zündelektroden 21 und 22. Die dabei durch die Gasentladung fließenden Ströme bauen diese Feldspitzen aber ab, so dass sich die Gasentladung nicht nur zwischen den Zündelektroden 21 und 22, sondern über weitere Bereiche der Elektroden 7, 8 ausbildet.

Die Ausführungsform der in **Fig. 2** dargestellten erfindungsgemäßen Vorrichtung unterscheidet sich von derjenigen in Fig. 1 in folgenden Details. Die Drehlager 3 und 4 sind hier als einfache Gleitlager ausgebildet, während in Fig. 1 Kugellager skizziert sind. Die Drehlager 3 und 4 sind dabei auch nicht von den elektrisch isolierenden Stirndeckeln 11 und 12 abgedeckt. Diese Unterschiede haben aber auf die Funktion der Vorrichtung keinen grundsätzlichen Einfluss. Mit den weiteren Unterschieden werden jedoch das Zünden und die gleichmäßige Verteilung der durch die Wechselhochspannung der Wechselhochspannungsgenerators 14 erzeugten Gasentladung weiter gefördert. Die Deckschichten 9 und 10 weisen hier anders als in Fig. 1 keine konstante Dicke, sondern eine mit zunehmendem Abstand zu der jeweils anderen Elektrode 8 bzw. 7 abnehmende Dicke auf. Auf diese Weise wird erreicht, dass sich die elektrischen Feldlinien über dem Außenumfang der Walze 1 nicht nur auf die axiale Mitte der Walze 1 über dem kürzesten geometrischen Abstand zwischen Elektroden 7, 8 konzentrieren. Konstruktiv realisiert sind die abnehmenden Dicken der Deckschichten 9 und 10 durch einen zur Mitte der Walze 1 hin konisch abnehmenden Außenumfang der Elektroden 7 und 8 und eine Vergussmasse 19 aus dielektrischem Material 6, die zusammen mit einem Formkörper 20 aus dielektrischem Material 6 den Kontaktmantel 5 ausbildet. Zur Verteilung der Gasentladung tragen in Umfangsrichtung um die Walzenachse 2 verlaufende Rillen 23 bei, mit denen der Kontaktmantel 5 an seinem Außenumfang versehen ist. Dabei können die Rillen 23 auch nach Art eines Außengewindes spiralförmig mit leichter Steigung um die Walzenachse 2 verlaufen. Die Rillen 23 führen zu einer Verteilung von Feldspitzen des durch die Wechselhochspannung des Wechselhochspannungsgenerators 17 hervorgerufenen elektrischen Felds über den gesamten Außenumfang des Kontaktmantels 5 hinweg.

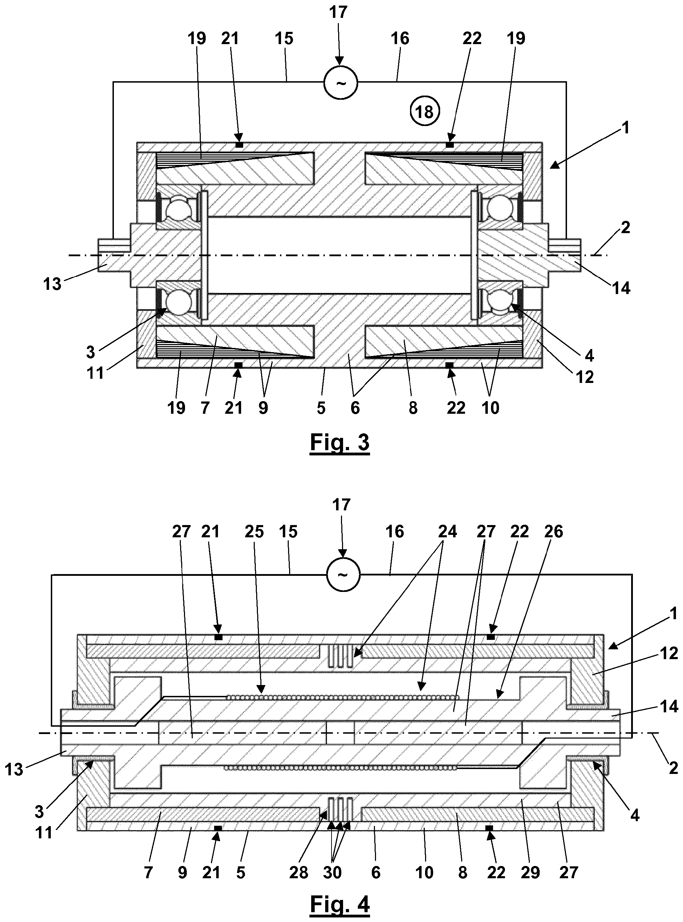

Die Ausführungsform der erfindungsgemäßen Vorrichtung gemäß **Fig. 3** unterscheidet sich von derjenigen gemäß Fig. 1 nur dadurch, dass hier der Außenumfang der Elektroden 7 und 8 in entgegengesetzter Richtung zu Fig. 2, d. h. zu den Enden der Walze 1 hin konisch abnimmt. In Verbindung mit den Zündelektroden 21 und 22 kann auch hierdurch eine gleichmäßige Verteilung der Gasentladung über dem Kontaktmantel 5 gefördert werden.

Die Ausführungsform der erfindungsgemäßen Vorrichtung gemäß **Fig. 4** unterscheidet sich von derjenigen gemäß Fig. 1 in anderen Details als diejenige gemäß Fig. 2, wobei diese Unterschiede auch zu einer weiteren, hier nicht dargestellten, Ausführungsform der erfindungsgemäßen Vorrichtung kombiniert werden können. Gemäß Fig. 4 umfasst die Walze 1 einen Transformator 24 mit einer Primärwicklung 25 um einen sich nicht mit der Walze drehenden Kern 26 aus ferritischem Material 27. Die Sekundärwicklung 28 des Transformators 24 ist in einem Tragkörper 29 aus ferritischem Material 27, konkret in Wickelkammern 30 des Tragkörpers 29 vorgesehen. Der Tragkörper 29 ist magnetisch an den Kern 26 angekoppelt, es versteht sich jedoch, dass sowohl die Primärwicklung 25 gegenüber dem Kern 26 als auch die Sekundärwicklung 28 gegenüber dem Tragkörper 29 elektrisch isoliert ist. Die Sekundärwicklung 28 ist an die beiden Elektroden 7 und 8 in dem Kontaktmantel 5 angeschlossen. Die Primärwicklung 25 ist hingegen an die Anschlüsse 15 und 16 des Wechselhochspannungsgenerators 17 angeschlossen, zwischen denen dieser die Wechselhochspannung generiert. Durch das Windungsverhältnis der Primärwicklung 25 zu der Sekundärwicklung 28 kann die von dem Wechselhochspannungsgenerator 17 generierte Wechselhochspannung in der Walze 1 auf das gewünschte Spannungsniveau hochtransformiert werden, das dann nur zwischen den dielektrisch abgeschirmten Elektroden 7, 8 vorliegt. Die Drehlager 3 und 4 sind hier als Gleitlager zwischen den Stirndeckeln 11 und 12 und dem Kern 26 ausgebildet.

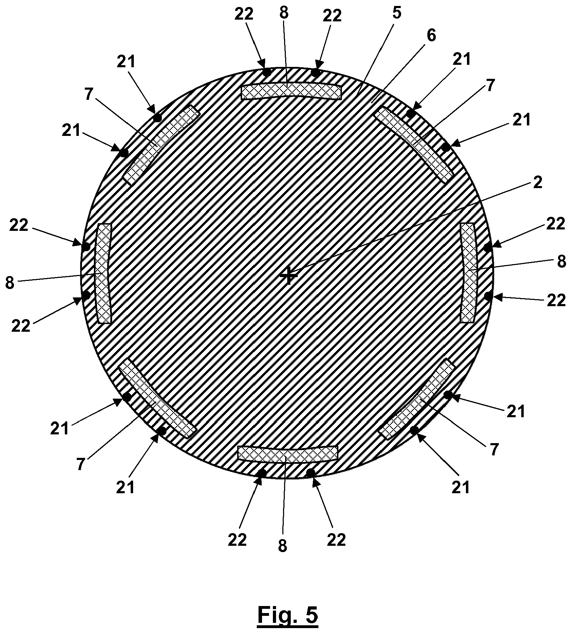

Die in **Fig. 5** skizzierte Ausführungsform der Erfindung ist ohne den Wechselhochspannungsgenerator 17 dargestellt. Zudem ist die Walze 1 anders als in den Fig. 1 bis 4 nicht in einem Längsschnitt, sondern in einem Querschnitt senkrecht zu der Walzenachse 2 wiedergegeben. Dabei sind hier in dem Kontaktmantel 5 längs der Walzenachse 2 langgestreckte Elektroden 7 und Gegenelektroden 8 in Umfangsrichtung um die Walzenachse alternierend aufeinander folgend angeordnet. Entsprechend sind auch die Zündelektroden 21, 22 langgestreckt ausgebildet, wobei hier je Elektrode 7 und Gegenelektrode 8 je zwei Zündelektroden 21 bzw. 22 vorgesehen sind. Dadurch bilden sich über den Umfang der Walze 1 hinweg elektrische Felder mit wechselnder Richtung aus, die jeweils die gewünschte dielektrisch behinderte Gasentladung über den gesamten Umfang der Walze 1 hervorrufen, soweit alle Elektroden 7 und 8 an den Wechselhochspannungsgenerator angeschlossen sind. Es können aber auch nur ausgewählte Elektroden 7 und 8 angeschlossen werden, die über einen bestimmten Umfangswinkel um die Walzenachse 2 verteilt sind. So kann die Gasentladung über dem Außenumfang des Kontaktmantels 5 beispielsweise auf einen Umschlingungswinkel fokussiert werden, über den hinweg die Walze 1 mit dem zu behandelnden bandförmigen Objekt umschlungen ist.

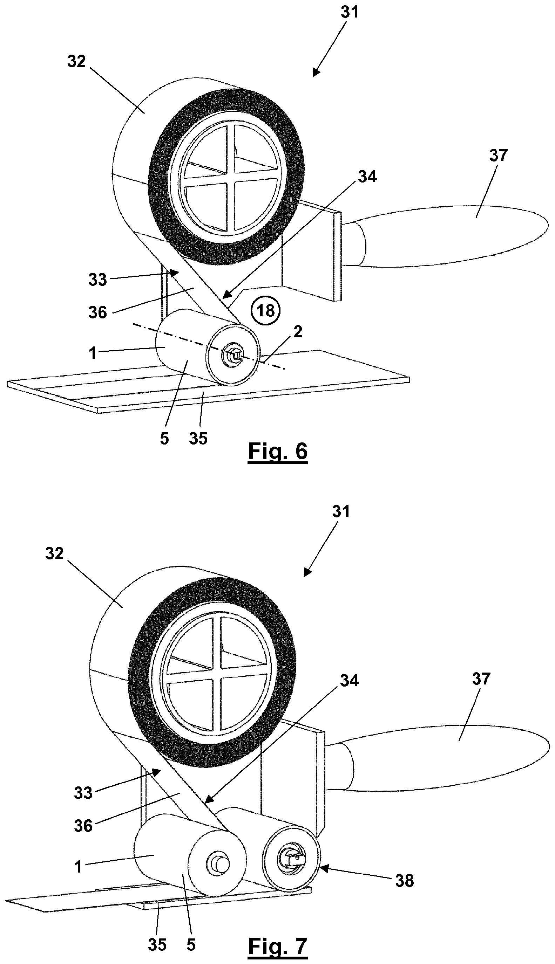

**Fig. 6** illustriert einen Klebebandabroller 31 für ein zu einer Vorratsrolle 32 aufgewickeltes Klebeband 33. Dieser Klebebandabroller 31 ist eine Anwendung der erfindungsgemäßen Vorrichtung und umfasst entsprechend die Walze 1 und auch den hier nicht dargestellten Wechselhochspannungsgenerator. Die Vorratsrolle ist um eine zu der Walzenachse 2 parallele Drehachse drehbar gelagert. Das von der Vorratsrolle abgezogene Klebeband 33 umschlingt die Walze 1 über einen Umschlingungswinkel um die Walzenachse 2 hinweg. Durch die über den gesamten Außenumfang des Kontaktmantels 5 der Walze 1 erzeugte Gasentladung wird das Klebeband 33 plasmabehandelt, hier konkret um es an seiner Klebeseite 34 zu aktivieren, bevor es mit seiner Klebeseite 34 an eine Oberfläche 35 angedrückt wird. Dieses Andrücken erfolgt ebenfalls mit der Walze 1. Das über der Oberfläche der Walze 1 ausgebildete Plasma wirkt dabei auch auf die Oberfläche 35 ein, bevor das Klebeband 33 an diese angedrückt wird. Die Rückseite 36 des Klebebands 33 erfährt im Zulauf und Ablauf von der Walze 1 ebenfalls eine Plasmabehandlung. Besonders kommt es jedoch auf die Plasmabehandlung der Klebeseite 34 an, bei der das Klebeband an dem Kontaktmantel 5 der Walze 1 anliegt, so dass sich das über dem Kontaktmantel 5 in der Gasatmosphäre 18 ausgebildete Plasma auch über dem Klebeband 33 und damit auf seiner Klebeseite 34 befindet. Zur manuellen Bedienung des Klebebandabrollers 31, d. h. zum Abrollen des Klebebands 33 mit der Walze 1 auf die Oberfläche ist ein Handgriff 37 vorgesehen.

Die Ausführungsform des Klebebandabrollers 31 für das Klebeband 33 gemäß **Fig. 7** unterscheidet sich von derjenigen gemäß Fig. 6 dadurch, dass eine weitere, um eine zu der Walzenachse 2 parallele Drehachse drehbar gelagerte Plasmabehandlungswalze 38 zur Vorbehandlung der Oberfläche 35 vor dem Andrücken des Klebebands 33 vorgesehen ist. Die Plasmabehandlungswalze 28 kann analog zu der Walze 1 ausgebildet sein, d. h. z. B. gemäß den Fig. 1 bis 4. Die Plasmabehandlungswalze 38 kann aber auch dem aus der WO 2013/156352 A2 bekannten Plasmaroller entsprechen.

### BEZUGSZEICHENLISTE

1 Walze
2 Walzenachse
3 Drehlager
4 Drehlager
5 Kontaktmantel
6 Dielektrisches Material
7 Elektrode
8 Gegenelektrode
9 Deckschicht
10 Deckschicht
11 Stirndeckel
12 Stirndeckel
13 Lagerbolzen
14 Lagerbolzen
15 Anschluss
16 Anschluss
17 Wechselhochspannungsgenerator
18 Gasatmosphäre
19 Vergussmasse
20 Formkörper
21 Zündelektrode
22 Zündelektrode
23 Rille
24 Transformator
25 Primärwicklung
26 Kern
27 Ferritisches Material
28 Sekundärwicklung
29 Tragkörper
30 Wickelkammer
31 Klebebandabroller
32 Vorratsrolle
33 Klebeband
34 Klebeseite
35 Oberfläche
36 Rückseite
37 Handgriff
38 Plasmabehandlungswalze

## Patentansprüche

1. Vorrichtung zur Plasmabehandlung eines Objekts mit
- einer Elektrode (7) und einer Gegenelektrode (8) aus elektrisch leitfähigem Material,
- einem Wechselhochspannungsgenerator (17), der ausgebildet und angeschlossen ist, um mit einer Wechselhochspannung eine Gasentladung zwischen der Elektrode (7) und der Gegenelektrode (8) hervorzurufen, und
- einer um eine Walzenachse (2) drehbar gelagerten Walze (1), die einen Kontaktmantel (5) zum Kontaktieren des Objekts aufweist,
- wobei die Elektrode (7) und die Gegenelektrode (8) nebeneinander in dem Kontaktmantel (5) angeordnet sind und
- wobei der Kontaktmantel (5) eine die Elektrode (7) und die Gegenelektrode (8) bedeckende Deckschicht (9, 10) aus dielektrischem Material (6) aufweist, die zwischen der Elektrode (7) und der Gegenelektrode (8) mit der Gasentladung in Reihe geschaltet ist, um die Gasentladung dielektrisch zu behindern,
**dadurch gekennzeichnet, dass** oberhalb der Elektrode (7) und/oder oberhalb der Gegenelektrode (8) eine durch die Deckschicht (9, 10) von der Elektrode (7) und der Gegenelektrode (8) getrennte und am Außenumfang des Kontaktmantels (5) frei liegende linienförmige Zündelektrode (21, 22) aus elektrisch leitfähigem Material angeordnet ist.

2. Vorrichtung nach Anspruch 1, **dadurch gekennzeichnet, dass** die Dicke der Deckschicht (9, 10) oberhalb der Elektrode (7) mit zunehmendem Abstand von der Gegenelektrode (8) und/oder die Dicke der Deckschicht (10) oberhalb der Gegenelektrode (8) mit zunehmendem Abstand von der Elektrode (7) abnimmt oder zunimmt.

3. Vorrichtung nach einem der vorhergehenden Ansprüche, **dadurch gekennzeichnet, dass** der Wechselhochspannungsgenerator (17) einen in der Walze (1) angeordneten Transformator (24) aufweist, dessen Primärwicklung (25) drehfest auf einem sich nicht mit der Walze (1) um die Walzenachse (2) drehenden Kern (26) angeordnet ist und dessen Sekundärwicklung (28) drehfest an dem Kontaktmantel (5) gelagert und endseitig an die Elektrode (7) einerseits und die Gegenelektrode (8) andererseits angeschlossen ist.

4. Vorrichtung nach einem der Ansprüche 1 bis 3, **dadurch gekennzeichnet, dass** die Elektrode (7) und die Gegenelektrode (8) in Richtung der Walzenachse (2) aufeinanderfolgen.

5. Vorrichtung nach einem der Ansprüche 1 bis 3, **dadurch gekennzeichnet, dass** mehrere Elektroden (7) und mehrere Gegenelektroden (8) in Umfangsrichtung um die Walzenachse (2) alternierend aufeinanderfolgen.

6. Vorrichtung nach Anspruch 5, **dadurch gekennzeichnet, dass** der Wechselhochspannungsgenerator (17) angeschlossen ist, um die Wechselhochspannung selektiv zwischen den Elektroden (7) und den Gegenelektroden (8) zu erzeugen, die sich aktuell innerhalb eines vorgegebenen Umfangswinkels um die Walzenachse (2) befinden.

7. Vorrichtung nach Anspruch 6, **dadurch gekennzeichnet, dass** der vorgegebene Umfangswinkel einen Umschlingungswinkel um die Walzenachse (2) umfasst, über den hinweg der Kontaktmantel (5) das bandförmige Objekt abstützt.

8. Vorrichtung nach einem der Ansprüche 4 bis 7, **dadurch gekennzeichnet, dass** der Kontaktmantel (5) an seinem Außenumfang mit Rillen (23) versehen ist, die in Umfangsrichtung um die Walzenachse (2) verlaufen, wenn die Elektrode (7) und die Gegenelektrode (8) in Richtung der Walzenachse (2) aufeinander folgen, und die parallel zu der Walzenachse (2) verlaufen, wenn mehrere Elektroden (7) und mehrere Gegenelektroden (8) in Umfangsrichtung um die Walzenachse (2) alternierend aufeinanderfolgen.

9. Vorrichtung nach einem der vorhergehenden Ansprüche, **dadurch gekennzeichnet, dass** ein Drehlager (3, 4) mit einer parallel zu der Walzenachse (2) verlaufenden Drehachse für das zu einer Vorratsrolle (32) aufgewickelte bandförmige Objekt vorgesehen ist, wobei der Kontaktmantel (5) das von der Vorratsrolle (32) ablaufende Objekt über einen Umschlingungswinkel um die Walzenachse (2) abstützt.

10. Vorrichtung nach Anspruch 9, **dadurch gekennzeichnet, dass** ein Handgriff (37) vorgesehen ist, um das bandförmige Objekt mit der Walze (1) oder einer separaten, um eine zu der Walzenachse (2) parallele Drehachse drehbar gelagerte Andrückwalze an eine Oberfläche (35) anzudrücken.

11. Vorrichtung nach Anspruch 10, **dadurch gekennzeichnet, dass** eine zusätzliche, um eine zu der Walzenachse (2) parallele Drehachse drehbar gelagerte Plasmabehandlungswalze (38) für eine Plasmavorbehandlung der Oberfläche (35) vorgesehen ist.

12. Vorrichtung nach einem der Ansprüche 9 bis 11, **dadurch gekennzeichnet, dass** das bandförmige Objekt ein Klebeband (33) ist, das der Kontaktmantel (5) an seiner nicht klebenden Rückseite (36) abstützt.

13. Vorrichtung nach einem der Ansprüche 1 bis 12, **dadurch gekennzeichnet, dass** der Wechselhochspannungsgenerator (17) die Wechselhochspannung mit einer Amplitude zwischen 5.000 V und 50.000 V und mit einer Frequenz zwischen 100 kHz und 3 MHz oder einer Frequenz zwischen 150 kHz und 600 kHz erzeugt.

14. Vorrichtung nach einem der Ansprüche 1 bis 13, **dadurch gekennzeichnet, dass** der Wechselhochspannungsgenerator (17) die Wechselhochspannung in untereinander beabstandeten Gruppen von Hochspannungspulsen alternierender Polarität generiert, wobei eine Anzahl der Wechselhochspannungspulse in den Gruppen und/oder eine Gruppenfolgefrequenz der Gruppen veränderbar ist, um eine Flächenleistungsdichte in der Gasentladung einzustellen.

15. Vorrichtung nach Anspruch 14, **dadurch gekennzeichnet, dass** die Gruppenfolgefrequenz mindestens 16 kHz beträgt.

## Claims

1. Apparatus for plasma treatment of an object, the apparatus comprising:
- an electrode (7) and a counter electrode (8) of electrically conductive material,
- an alternating high voltage generator (17) which is designed and connected to cause a gas discharge between the electrode (7) and the counter electrode (8) by means of an alternating high voltage, and
- a roller (1) which is mounted rotatably about a roller axis (2) and which has a contact jacket (5) for contacting the object,
- wherein the electrode (7) and the counter electrode (8) are arranged side by side within the contact jacket (5), and
- wherein the contact jacket (5) comprises a cover layer (9, 10) of dielectric material (6) which covers the electrode (7) and the counter electrode (8) and which is connected in series with the gas discharge between the electrode (7) and the counter electrode (8) to provide a dielectric barrier to the gas discharge,
**characterised in that** a line-shaped ignition electrode (21, 22) of electrically conductive material, which is separated from the electrode (7) and the counter electrode (8) by the cover layer (9, 10) and which is exposed at the outer circumference of the contact jacket (5), is arranged above the electrode (7) and/or above the counter electrode (8).

2. Apparatus of claim 1, **characterised in that** the thickness of the cover layer (9, 10) above the electrode (7) increases or decreases with increasing distance to the counter electrode (8) and/or the thickness of the cover layer (10) above the counter electrode (8) increases or decreases with increasing distance to the electrode (7).

3. Apparatus of any of the preceding claims, **characterised in that** the alternating high voltage generator (17) comprises a transformer (24) arranged within the roller (1), whose primary winding (25) is arranged on and fixed for rotation to a core (26) not rotating with the roller (1) about the roller axis (2), and whose secondary winding (28) is fixed for rotation to the contact jacket (5) and connected to the electrode (7) with its one end and to the counter electrode (8) with its other end.

4. Apparatus of any of the claims 1 to 3, **characterised in that** the electrode (7) and the counter electrode (8) follow to each other in direction of the roller axis (2).

5. Apparatus of any of the claims 1 to 3, **characterised in that** a plurality of electrodes (7) and a plurality of counter electrodes (8) alternatingly follow to each other in circumferential direction around the roller axis (2).

6. Apparatus of claim 5, **characterised in that** the alternating high voltage generator (17) is connected to selectively generate the alternating high voltage between the electrodes (7) and the counter electrodes (8) which are presently in a predetermined peripheral angle about the roller axis (2).

7. Apparatus of claim 6, **characterised in that** the predetermined peripheral angle includes an angle of wrap over which the contact jacket (5) supports the band-shaped object.

8. Apparatus of any of the claims 4 to 7, **characterised in that** the contact jacket (5), at its outer circumference, is provided with grooves (23) which extend in circumferential direction around the roller axis (2), if the electrode (7) and the counter electrode (8) follow to each other in direction of the roller axis (2), and which parallel the roller axis (2), if a plurality of electrodes (7) and a plurality of counter electrodes (8) alternatingly follow to each other in circumferential direction around the roller axis (2).

9. Apparatus of any of the preceding claims, **characterised in that** a rotation bearing (3, 4) is provided for the band-shaped object coiled up into a supply coil (32), which has a rotational axis parallel to the roller axis (2), wherein the contact jacket (5) supports the object coming from the supply coil (32) over a wrap angle about the roller axis (2).

10. Apparatus of claim 9, **characterised in that** a handle (37) is provided to press the band-shaped object against a surface (35) with the roller (1) or with a separate pressing roller, which is rotatably mounted about a rotation axis parallel to the roller axis (2).

11. Apparatus of claim 10, **characterised in that** an additional plasma treating roller, which is rotatably mounted about a rotation axis parallel to the roller axis (2), is provided for a plasma treatment of the surface (35).

12. Apparatus of any of the claims 9 to 11, **characterised in that** the band-shaped object is an adhesive band (33) which is supported at its non-adhesive back (36) by the contact jacket (5).

13. Apparatus of any of the claims 1 to 12, **characterised in that** the alternating high voltage generator (17) generates the alternating high voltage at an amplitude between 5,000 V and 50,000 V and at a frequency between 100 kHz and 3 MHz or at a frequency between 150 kHz and 600 kHz.

14. Apparatus of any of the claims 1 to 13, **characterised in that** the alternating high voltage generator (17) generates the alternating high voltage in groups of high voltage pulses of alternating polarity, the groups following to each other at intervals in time, wherein a number of the alternating high voltage pulses in the groups and/or a group repetition frequency of the groups is variable to adjust an areal power density in the gas discharge.

15. Apparatus of claim 14, **characterised in that** the group repetition frequency is at least 16 kHz.

## Revendications

1. Dispositif de traitement au plasma d'un objet avec
- une électrode (7) et une contre-électrode (8) en matériau électro-conducteur,
- un générateur de haute tension alternative (17) qui est conçu et branché pour provoquer, avec une haute tension alternative, une décharge de gaz entre l'électrode (7) et la contre-électrode (8) et
- un rouleau (1) logé de manière rotative autour d'un axe de rouleau (2), qui comprend une enveloppe de contact (5) pour le contact avec l'objet,
- l'électrode (7) et la contre-électrode (8) étant juxtaposées dans l'enveloppe de contact (5) et
- l'enveloppe de contact (5) comprenant une couche de recouvrement (9, 10) en matériau diélectrique (6) recouvrant l'électrode (7) et la contre-électrode (8), qui est branchée en série entre l'électrode (7) et la contre-électrode (8) avec la décharge de gaz, afin d'empêcher la décharge de gaz de manière diélectrique,
**caractérisé en ce que**, au-dessus de l'électrode (7) et/ou au-dessus de la contre-électrode (8) est disposée une électrode d'allumage (21, 22) en matériau électro-conducteur, de forme linéaire, séparée par la couche de recouvrement (9, 10), de l'électrode (7) et de la contre-électrode (8) et disposée librement sur la circonférence externe de l'enveloppe de contact (5).

2. Dispositif selon la revendication 1, **caractérisé en ce que** l'épaisseur de la couche de recouvrement (9, 10) au-dessus de l'électrode (7) diminue ou augmente lorsque la distance par rapport à la contre-électrode (8) augmente et/ou l'épaisseur de la couche de recouvrement (10) au-dessus de la contre-électrode (8) diminue ou augmente lorsque la distance par rapport à l'électrode (7) diminue ou augmente.

3. Dispositif selon l'une des revendications précédentes, **caractérisé en ce que** le générateur de haute tension alternative (17) comprend un transformateur (24) disposé dans le rouleau (1), dont l'enroulement primaire (25) est disposé de manière fixe en rotation sur un noyau (26) ne tournant pas avec le rouleau (1) autour de l'axe de rouleau (2) et dont l'enroulement secondaire (28) est logé de manière fixe en rotation sur l'enveloppe de contact (5) et est raccordé, au niveau de ses extrémités à l'électrode (7) d'une part et à la contre-électrode (8) d'autre part.

4. Dispositif selon l'une des revendications 1 à 3, **caractérisé en ce que** l'électrode (7) et la contre-électrode (8) se succèdent en direction de l'axe de rouleau (2).

5. Dispositif selon l'une des revendications 1 à 3, **caractérisé en ce que** plusieurs électrodes (7) et plusieurs contre-électrodes (8) se succèdent de manière alternée dans la direction circonférentielle autour de l'axe de rouleau (2).

6. Dispositif selon la revendication 5, **caractérisé en ce que** le générateur de haute tension alternative (17) est branché pour générer la haute tension alternative de manière sélective entre les électrodes (7) et les contre-électrodes (8), qui se trouvent actuellement à l'intérieur d'un angle de circonférence prédéterminé autour de l'axe de rouleau (2).

7. Dispositif selon la revendication 6, **caractérisé en ce que** l'angle de circonférence prédéterminé comprend un angle d'enroulement autour de l'axe de rouleau (2) sur lequel l'enveloppe de contact (5) s'appuie contre l'objet en forme de bande.

8. Dispositif selon l'une des revendications 4 à 7, **caractérisé en ce que** l'enveloppe de contact (5) est muni, sur sa circonférence externe, de rainures (23) qui s'étendent dans la direction circonférentielle autour de l'axe de rouleau (2) lorsque l'électrode (7) et la contre-électrode (8) se succèdent en direction de l'axe de rouleau (2) et qui s'étendant parallèlement à l'axe de rouleau (2) lorsque plusieurs électrodes (7) et plusieurs contre-électrodes (8) se succèdent de manière alternée dans la direction circonférentielle autour de l'axe de rouleau (2).

9. Dispositif selon l'une des revendications précédentes, **caractérisé en ce qu'**un palier rotatif (3, 4) avec un axe de rotation s'étendant parallèlement à l'axe du rouleau (2) pour l'objet en forme de bande enroulé en un rouleau de réserve (32), l'enveloppe de contact (5) appuyant l'objet sortant du rouleau de réserve (32) sur un angle d'enroulement autour de l'axe du rouleau (2).

10. Dispositif selon la revendication 9, **caractérisé en ce qu'**une poignée (37) est prévue, afin de comprimer l'objet en forme de bande avec le rouleau (1) ou avec un rouleau de compression séparé logé de manière rotative autour d'un axe de rotation parallèle à l'axe du rouleau (2), contre une surface (35).

11. Dispositif selon la revendication 10, **caractérisé en ce qu'**un rouleau de traitement au plasma (38) supplémentaire, logé de manière rotative autour d'un axe de rotation parallèle à l'axe de rouleau (2), est prévu pour un traitement au plasma de la surface (35).

12. Dispositif selon l'une des revendications 9 à 11, **caractérisé en ce que** l'objet en forme de bande est une bande adhésive (33) qui appuie l'enveloppe de contact (5) contre son côté arrière (36) non adhésif.

13. Dispositif selon l'une des revendications 1 à 12, **caractérisé en ce que** le générateur de haute tension alternative (17) génère la haute tension alternative avec une amplitude entre 5 000 V et 50 000 V avec une fréquence entre 100 kHz et 3 MHz ou une fréquence entre 150 kHz et 600 Khz.

14. Dispositif selon l'une des revendications 1 à 13, **caractérisé en ce que** le générateur de haute tension alternative (17) génère la haute tension alternative par groupes distants entre eux d'impulsions de haute tension de polarités alternées, un nombre d'impulsions de haute tension alternative dans les groupes et/pou une fréquence de suite des groupes étant variable, afin de régler une densité de rendement surfacique dans la décharge de gaz.

15. Dispositif selon la revendication 14, **caractérisé en ce que** la fréquence de suite de groupes est d'au moins 16 kHz.
